# FASCICULE DE BREVET EUROPEEN

(11) **EP 3 069 157 B1**
(45) Date de publication et mention de la délivrance du brevet: **08.11.2017**
(21) Numéro de dépôt: 14799416.4
(22) Date de dépôt: 14.11.2014
(51) Int. Cl.: G01R 31/40, G01R 31/26, H01L 31/18

(54) **DISPOSITIF DE TEST D'UN MODULE PHOTOVOLTAIQUE A CONCENTRATION**
VORRICHTUNG ZUM TESTEN EINES KONZENTRIERTEN FOTOVOLTAIKMODULS
DEVICE FOR TESTING A CONCENTRATED PHOTOVOLTAIC MODULE

(30) Priorité: 14.11.2013 FR 1361142
(43) Date de publication de la demande: 21.09.2016
(73) Titulaire: Saint-Augustin Canada Electric Inc., Saint-Augustin de Desmaures, Québec G3A 1S5 (CA)
(72) Inventeur: GASTALDO, Philippe, F-38530 Pontcharra (FR)
(74) Mandataire: Grünecker Patent- und Rechtsanwälte PartG mbB
(86) Numéro de dépôt international: PCT/EP2014/074635
(87) Numéro de publication internationale: WO 2015/071425

(56) Documents cités:
- WO-A1-2010/003115

## Description

### DOMAINE DE L'INVENTION

La présente invention concerne un dispositif et un procédé de test d'un module photovoltaïque à concentration.

### ARRIERE PLAN DE L'INVENTION

Un module photovoltaïque à concentration (CPV, acronyme du terme anglo-saxon « Concentration PhotoVoltaic ») comprend essentiellement une cellule photovoltaïque (par exemple multi-jonctions) et un concentrateur destiné à concentrer le rayonnement solaire vers ladite cellule.

Dans le cas d'une cellule multi-jonctions, les différentes jonctions sont agencées en série, chacune des jonctions étant adaptée à une bande spectrale spécifique du rayonnement solaire. Le document WO2010/003115A décrit un dispositif de test pour modules photovoltaïques. Les cellules multi-jonctions, qui sont de plus petites dimensions que les cellules solaires en silicium conventionnelles, présentent l'avantage d'offrir un meilleur rendement, mais nécessitent pour fonctionner une intensité lumineuse plus élevée.

Dans un module CPV, les cellules sont associées à un concentrateur, par exemple une lentille de Fresnel, qui concentre le rayonnement solaire vers la cellule.

En outre, les modules photovoltaïque sont destinés à être monté sur un système suiveur de soleil (également appelé « tracker » dans la terminologie anglo-saxonne) de sorte à orienter de manière optimale le module en fonction de la trajectoire du soleil pour que les concentrateurs focalisent les rayons du soleil sur les cellules.

Lors de la fabrication de tels modules photovoltaïques, il est habituel de vérifier le fonctionnement et les performances de chaque module, en vue de détecter une éventuelle défaillance de l'une des jonctions, des défauts de qualité ou de positionnement des concentrateurs, ou toute autre anomalie du module avant que celui-ci ne soit expédié..

Il est fréquent que les modules soient combinés en étant montés totalement ou partiellement en série. Dans ce cas, les performances du système global seront limitées par l'élément le plus faible. Il peut donc s'avérer utile de sélectionner les modules devant être combinés afin qu'ils soient homogènes en réponse. Dans cet objectif, il est important de pouvoir mesurer la performance de ce module.

A cet effet, il est connu de simuler l'éclairement du soleil au moyen d'un dispositif d'éclairement généralement appelé « flasher », qui génère un faisceau lumineux présentant une irradiance, une distribution spectrale de puissance et une divergence angulaire proches de celles du soleil. Ces caractéristiques devront être conformes sur l'ensemble de la surface du module à tester.

Les modules CPV présents actuellement sur le marché présentent des dimensions relativement faibles (de l'ordre de 0,5 à 1,5 m²).

Il existe des dispositifs d'éclairement qui permettent de simuler l'éclairement solaire sur un module de ce type.

La société Soitec a mis sur le marché des modules solaires de grandes dimensions, présentant une surface de plusieurs m², comprenant plusieurs sous-modules CPV solidarisés par un châssis unique.

Ainsi, par exemple, un module de 8 m² peut être formé de deux rangées de six sous-modules, qui peuvent éventuellement être connectés en série.

Il se pose donc le problème de pouvoir tester un module de grandes dimensions. En effet, les sous-modules étant connectés totalement ou partiellement en série et leur intégrité mécanique étant assurée par un châssis unique, ils ne peuvent être testés indépendamment.

D'autre part, il est important de garantir le fonctionnement de l'ensemble assemblé avant qu'il ne soit installé.

Il est donc nécessaire de pouvoir vérifier les performances du module complet, en simulant un éclairement qui soit le plus proche possible du rayonnement solaire.

A cet égard, les contraintes que doit respecter le dispositif d'éclairement sont les suivantes :
- une irradiance comparable à celle produite par le soleil au niveau du sol, c'est-à-dire de l'ordre de 1 kW/m²,
- la reproduction du spectre solaire complet, de l'ultraviolet à l'infrarouge, en respectant les densités spectrales,
- une divergence angulaire proche de celle de la lumière solaire, c'est-à-dire de 0,5° (± 0,25°),
- une grande uniformité spatiale de l'irradiance (l'objectif étant une inhomogénéité de l'irradiance inférieure ou égale à 5%).

Les dispositifs d'éclairement connus ne répondent pas à ces exigences pour un module de grandes dimensions.

En effet, ces dispositifs offrent soit un champ plus réduit, soit des caractéristiques (notamment la divergence angulaire) trop éloignées de celles du soleil.

Une autre contrainte à prendre en compte pour concevoir le dispositif d'éclairement est la compacité de l'installation de test.

Ainsi, il n'est pas envisageable de placer une source lumineuse loin du module pour obtenir une faible divergence angulaire car, compte tenu de la surface du module, cela impliquerait une distance de plusieurs dizaines de mètres, non compatible avec une installation industrielle.

Pour préserver la compacité du dispositif de test, il est envisagé d'utiliser une pluralité de miroirs.

Cependant, il se pose alors un problème économique lié au coût des miroirs paraboliques.

En effet, dans la mesure où des défauts de surface du miroir parabolique du dispositif d'éclairement sont susceptibles d'affecter l'homogénéité de l'intensité lumineuse envoyée vers le module, on emploie généralement des miroirs de très haute qualité, tels que les miroirs employés en astronomie.

Ces miroirs sont très onéreux.

Pour les dispositifs connus n'employant qu'un seul miroir, ce coût est acceptable.

En revanche, il serait économiquement très pénalisant d'employer une pluralité de tels miroirs dans le dispositif de test envisagé.

Il est également possible de fabriquer un miroir en moulant ou en thermoformant une plaque d'un matériau plastique puis en déposant sur celle-ci un film réfléchissant.

Cependant, l'état de surface obtenu par cette technique n'est pas satisfaisant.

Même si des défauts de surface de très faible amplitude sont présents sur le miroir, ils peuvent, du fait de la distance entre le miroir et le module à tester, engendrer une variation importante de l'intensité lumineuse parvenant sur le module.

Il est donc nécessaire de trouver une solution pour procurer l'homogénéité attendue pour l'intensité lumineuse délivrée par la source, qui soit moins onéreuse que les techniques existantes.

Un but de l'invention est de concevoir un dispositif de test d'un module photovoltaïque à concentration de grandes dimensions, qui respecte les contraintes mentionnées ci-dessus, et qui offre notamment une très bonne homogénéité de l'intensité lumineuse et qui présente un coût inférieur à celui des dispositifs existants.

### BREVE DESCRIPTION DE L'INVENTION

Conformément à l'invention, il est proposé un dispositif de test d'un module photovoltaïque à concentration comprenant au moins un ensemble d'une cellule photovoltaïque et d'un concentrateur agencé par rapport à la cellule pour concentrer vers ladite cellule un rayonnement arrivant en incidence normale, ledit dispositif étant caractérisé en ce qu'il comprend :
- au moins une source lumineuse,
- au moins un miroir parabolique couplé à ladite source de manière à renvoyer la lumière issue de ladite source dans un faisceau lumineux quasi collimaté vers le module à tester, dans une direction perpendiculaire à la surface dudit module, et
- un filtre d'intensité interposé sur le trajet du faisceau quasi collimaté en amont du module à tester, ledit filtre comprenant des régions au moins partiellement absorbantes à densité spectrale neutre vis-à-vis du faisceau lumineux, lesdites régions au moins partiellement absorbantes étant agencées en vis-à-vis des zones de plus forte intensité du faisceau, de sorte à atténuer les différences d'intensité du faisceau.

Par faisceau quasi collimaté, on entend dans le présent texte un faisceau dont la divergence est faible, typiquement inférieure à 1°. Dans la présente invention, afin de reproduire la divergence du soleil, le faisceau quasi collimaté a une divergence de +/-0,25°.

De manière connue en elle-même, chaque faisceau quasi collimaté est obtenu en plaçant l'orifice de chaque source lumineuse au foyer ou au voisinage du foyer du miroir parabolique auquel il est couplé, l'homme du métier étant en mesure de définir les caractéristiques dimensionnelles de l'orifice et du couple miroir-source pour obtenir un tel faisceau quasi-collimaté.

Bien que l'invention soit particulièrement avantageuse pour un module de grandes dimensions comprenant une pluralité de sous-modules, le dispositif décrit ci-dessus présente également un avantage notable pour le test d'un module unitaire de dimensions réduites, dans la mesure où le filtre d'intensité est une solution moins onéreuse que les miroirs de très haute qualité connus pour assurer une répartition homogène de l'intensité du faisceau lumineux.

Selon un mode de réalisation, le filtre d'intensité comprend un support transparent audit faisceau quasi collimaté et un film collé sur ledit support, ledit film comprenant des régions au moins partiellement absorbantes à densité spectrale neutre vis-à-vis du faisceau quasi collimaté, lesdites régions au moins partiellement absorbantes correspondant aux zones de plus forte intensité du faisceau.

De manière alternative, le filtre d'intensité comprend un support transparent audit faisceau quasi collimaté, ledit support comprenant une couche d'impression comportant des régions au moins partiellement absorbantes à densité spectrale neutre vis-à-vis du faisceau quasi collimaté, lesdites régions au moins partiellement absorbantes correspondant aux zones de plus forte intensité du faisceau.

Les régions au moins partiellement absorbantes du filtre sont avantageusement constituées de motifs élémentaires, lesdits motifs comprenant des motifs transparents et des motifs opaques au faisceau lumineux.

Selon une forme d'exécution particulière, lesdits motifs élémentaires présentent une forme carrée ou rectangulaire.

Le miroir parabolique peut avantageusement comprendre une plaque de verre recouverte d'un film réfléchissant ou d'un empilement de couches minces réfléchissantes.

Selon un mode de réalisation préféré, le dispositif de test est adapté pour tester un module photovoltaïque à concentration comprenant une pluralité de sous-modules photovoltaïque comprenant chacun au moins un ensemble d'une cellule photovoltaïque et d'un concentrateur.

Dans ce cas, ledit dispositif comprend une pluralité de sources lumineuses et une pluralité de miroirs paraboliques couplés auxdites sources de manière à envoyer des faisceaux quasi collimatés vers le module à tester et un filtre d'intensité est interposé sur le trajet de chaque faisceau quasi collimaté en amont du module à tester, chaque filtre d'intensité comprenant des régions au moins partiellement absorbantes à densité spectrale neutre vis-à-vis du faisceau lumineux, lesdites régions au moins partiellement absorbantes étant agencées en vis-à-vis des zones de plus forte intensité du faisceau, de sorte à atténuer les différences d'intensité de chaque faisceau.

Le dispositif peut en outre comprendre un support pour le module à tester, les sources lumineuses étant agencées selon deux rangées s'étendant de part et d'autre de l'emplacement du module sur ledit support.

De manière préférée, les miroirs paraboliques sont alors agencés de sorte à former deux rangées horizontales en vis-à-vis du support du module à tester.

Un autre objet concerne un procédé de test d'un module photovoltaïque à concentration, ledit module comprenant au moins un ensemble d'une cellule photovoltaïque et d'un concentrateur agencé par rapport à la cellule pour concentrer vers ladite cellule un rayonnement arrivant en incidence normale, ledit procédé étant caractérisé en ce que l'on envoie vers ledit module au moins un faisceau lumineux quasi collimaté au moyen d'au moins une source lumineuse couplée à un miroir parabolique, et en ce que l'on interpose sur le trajet dudit faisceau lumineux quasi collimaté en amont du module à tester, un filtre d'intensité comprenant des régions au moins partiellement absorbantes à densité spectrale neutre vis-à-vis du faisceau lumineux, lesdites régions au moins partiellement absorbantes étant agencées en vis-à-vis des zones de plus forte intensité du faisceau, de sorte à atténuer les différences d'intensité du faisceau.

Selon un mode de réalisation, on forme ledit filtre d'intensité en collant, sur un support transparent audit faisceau quasi collimaté, un film comprenant des régions au moins partiellement absorbantes vis-à-vis du faisceau quasi collimaté, lesdites régions au moins partiellement absorbantes correspondant aux zones de plus forte intensité du faisceau.

Selon un autre mode de réalisation, on forme ledit filtre d'intensité en imprimant, sur un support transparent audit faisceau quasi collimaté, des régions au moins partiellement absorbantes à densité spectrale neutre vis-à-vis du faisceau quasi collimaté, lesdites régions au moins partiellement absorbantes correspondant aux zones de plus forte intensité du faisceau.

De manière avantageuse, on forme le miroir parabolique en thermoformant une plaque de verre ou de plastique puis en la recouvrant d'un film réfléchissant ou d'un empilement de couches minces réfléchissantes.

Selon une forme d'exécution préférée de l'invention, le module photovoltaïque à tester comprend une pluralité de sous-modules photovoltaïques et l'on envoie vers ledit module une pluralité de faisceaux lumineux quasi collimatés au moyen d'une pluralité de sources lumineuses couplées à une pluralité de miroirs paraboliques ; on interpose sur le trajet de chaque faisceau lumineux quasi collimaté en amont du module à tester, un filtre d'intensité comprenant des régions au moins partiellement absorbantes à densité spectrale nulle vis-à-vis du faisceau lumineux, lesdites régions au moins partiellement absorbantes étant agencées en vis-à-vis des zones de plus forte intensité du faisceau, de sorte à atténuer les différences d'intensité de chaque faisceau.

On peut utiliser autant de sources lumineuses, de miroirs paraboliques et de filtres d'intensité que de sous-modules du module photovoltaïque à tester, chaque source lumineuse et chaque miroir parabolique étant couplés de sorte à envoyer un faisceau lumineux quasi collimaté vers un sous-module correspondant.

Selon un mode de réalisation particulier, la surface du module à tester est supérieure ou égale à 8 m².

De manière particulièrement avantageuse, on définit les régions au moins partiellement absorbantes du filtre d'intensité en mettant en oeuvre les étapes suivantes :
- acquisition d'une image du faisceau quasi collimaté provenant du miroir parabolique,
- détermination, sur ladite image, des zones du faisceau de plus forte intensité,
- décomposition desdites zones de l'image en motifs élémentaires,
- attribution à chaque motif élémentaire d'un caractère transparent ou opaque vis-à-vis du flux lumineux, de sorte à former, en vis-à-vis desdites zones de plus forte intensité du faisceau lumineux, des régions au moins partiellement absorbantes constituées desdits motifs.

### BREVE DESCRIPTION DES DESSINS

D'autres caractéristiques et avantages de l'invention ressortiront de la description détaillée qui va suivre, en référence aux dessins annexés sur lesquels :
- la figure 1A est un schéma de principe d'un module photovoltaïque à concentration comprenant plusieurs sous-modules connectés en série ;
- la figure 1B est un schéma de principe d'un ensemble cellule photovoltaïque - concentrateur appartenant à un sous-module d'un tel module,
- la figure 2 est une vue d'ensemble d'un dispositif de test selon un mode de réalisation de l'invention,
- la figure 3 est un schéma de principe d'un ensemble d'une source lumineuse, d'un miroir et d'un filtre d'intensité appartenant à un dispositif de test selon l'invention,
- la figure 4 est un schéma de principe d'un dispositif permettant de définir le filtre d'intensité à interposer sur le trajet du faisceau lumineux,
- les figures 5A et 5B sont des images respectivement de l'intensité lumineuse produite par un ensemble source lumineuse - miroir parabolique et du filtre négatif permettant de compenser les effets des défauts de surface dudit miroir sur l'intensité du faisceau lumineux,
- la figure 6 présente un exemple de région au moins partiellement absorbante du filtre, constituée d'un ensemble de motifs transparents et opaques.

### DESCRIPTION DETAILLEE DE L'INVENTION

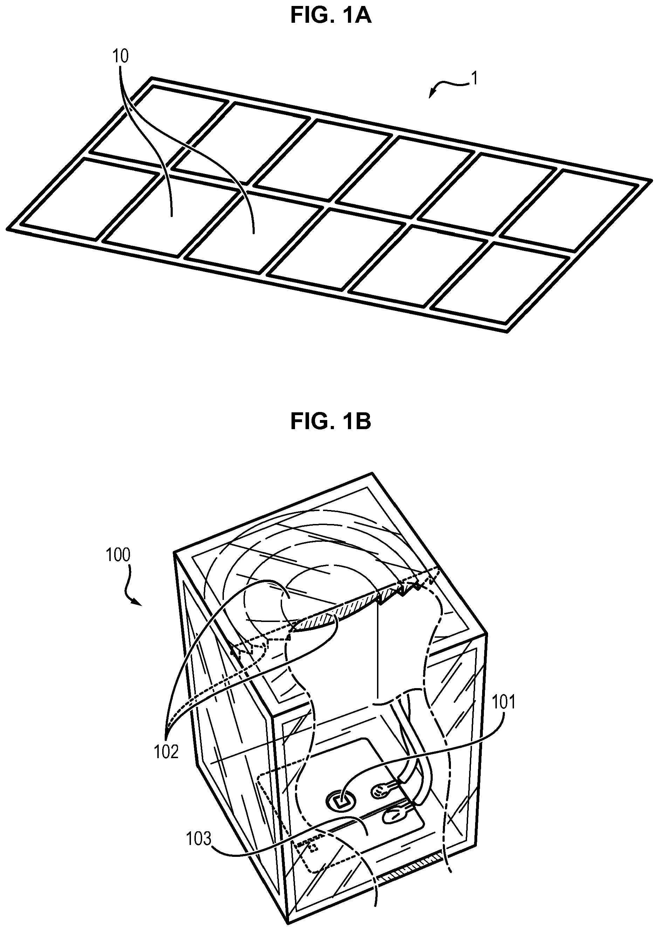

La figure 1A est un schéma de principe d'un module photovoltaïque que l'invention permet de tester.

Ledit module 1 à tester comprend une pluralité de sous-modules photovoltaïques à concentration 10.

Chaque sous-module 10 comprend une pluralité d'ensembles cellule - concentrateur.

Comme illustré sur la figure 1B, chaque ensemble 100 comprend essentiellement une cellule photovoltaïque 101 (par exemple multi-jonctions) et un concentrateur 102 destiné à concentrer vers ladite cellule 101 le rayonnement solaire arrivant en incidence normale. De manière optionnelle, la cellule 101 est placée sur un dissipateur de chaleur 103 pour limiter son élévation de température.

Le concentrateur 102 est constitué par exemple d'une lentille de Fresnel.

Dans le présent texte, la surface du module à tester est la surface des concentrateurs.

Les sous-modules 10 formant le module 1 peuvent éventuellement être électriquement connectés en série ou en parallèle.

La surface de chaque sous-module 10 présente une forme généralement rectangulaire, dont la largeur et la hauteur sont respectivement comprises dans les gammes suivantes : entre 30 et 80 cm de largeur, par exemple 60 cm, et entre 60 et 150 cm de hauteur, par exemple 120 cm.

Les sous-modules 10 sont typiquement agencés sous forme de rangées et/ou colonnes pour former le module.

Par exemple, un module de 8 m² peut être formé de deux rangées de six sous-modules, chaque sous-module présentant une surface d'environ 0,7 m².

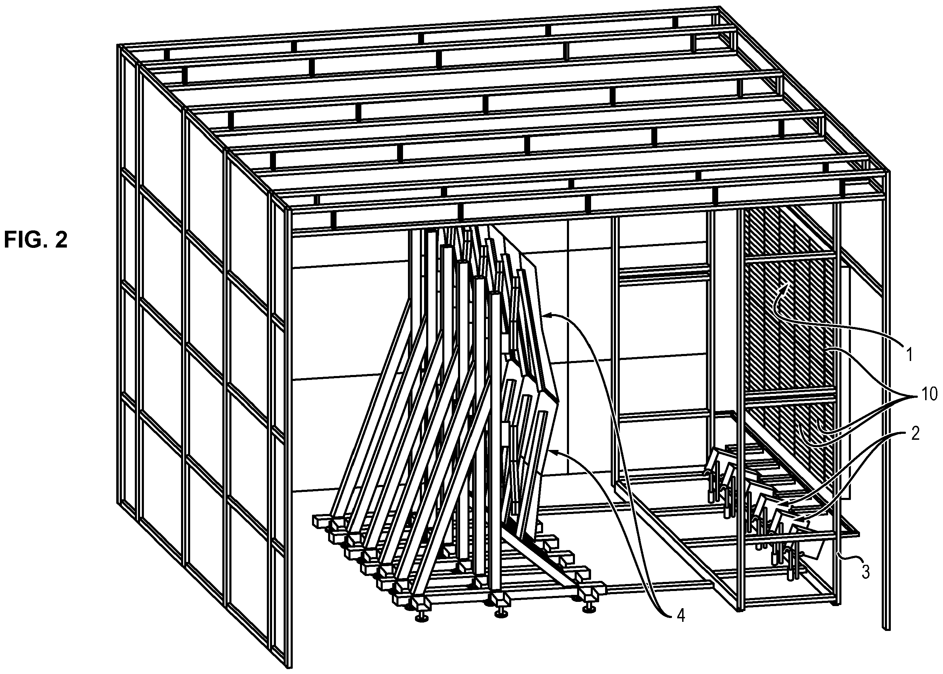

La figure 2 est une vue d'ensemble d'un dispositif de test conforme à l'invention.

Le dispositif comprend un support 3 pour le module 1 à tester.

De préférence, le support 3 est agencé de sorte que la surface du module à tester soit verticale.

Par « verticale », on entend dans le présent texte une direction perpendiculaire au plancher du bâtiment dans lequel le dispositif de test est installé.

En regard du support 3, le dispositif de test comprend une pluralité de sources lumineuses 2 et une pluralité de miroirs paraboliques 4 couplés aux sources lumineuses de manière à réfléchir la lumière issue de chaque source en un faisceau lumineux quasi collimaté dans une direction perpendiculaire à la surface du module..

Selon un mode de réalisation préféré, chaque source est agencée au foyer du miroir parabolique correspondant.

Dans ce cas, le dispositif de test comprend donc autant de sources que de miroirs.

Ceci permet d'utiliser une pluralité de miroirs identiques, dont la position et l'orientation sont ajustées de sorte à renvoyer vers le module à tester un faisceau quasi collimaté perpendiculaire à la surface dudit module.

Selon un autre mode de réalisation, chaque source lumineuse peut être couplée à plusieurs miroirs, dans la mesure où ces miroirs sont agencés de sorte que leurs foyers soient confondus, la source étant agencée à l'emplacement de ces foyers.

Dans le mode de réalisation illustré sur la figure 2, où le module 1 comprend deux rangées horizontales de six sous-modules 10, le dispositif de test comprend douze sources lumineuses 2 disposées selon deux rangées horizontales de part et d'autre du module 1, et douze miroirs paraboliques 4 disposés selon deux rangées horizontales en regard du module 1.

Chaque source et le miroir parabolique correspondant sont orientés l'un par rapport à l'autre de sorte que le faisceau lumineux renvoyé par le miroir soit perpendiculaire à la surface du sous-module correspondant.

La distance entre les sources et les miroirs paraboliques est définie de sorte que le faisceau lumineux quasi collimaté renvoyé par chaque miroir éclaire avec les caractéristiques souhaitées la totalité de la surface du sous-module correspondant.

Cette distance, ainsi que la surface des miroirs, dépend donc de la surface des sous-modules du module à tester.

Sans vouloir être limitatif, on considère qu'une distance de l'ordre de 2 à 6 mètres mesurée au sol entre les miroirs paraboliques et les sources lumineuses - qui détermine la majeure partie de la surface au sol du dispositif de test - est raisonnable.

Il n'est cependant pas indispensable que le nombre de sources lumineuses et de miroirs paraboliques soit identique au nombre de sous-modules du module photovoltaïque à tester.

En effet, si la surface de chaque sous-module est suffisamment faible, on peut prévoir qu'un couple source lumineuse - miroir parabolique éclaire plusieurs sous-modules tout en conservant un encombrement au sol acceptable du dispositif de test et une taille de miroir qui ne grève pas son coût de fabrication.

D'autre part, il peut exister des zones, à la frontière entre des faisceaux quasi collimatés adjacents, dans lesquelles l'intensité ne remplit pas les critères d'uniformité ou de divergence.

Dans ce cas, on agence avantageusement les sources lumineuses et les miroirs paraboliques de sorte à ce que des zones non illuminées par les faisceaux quasi collimatés envoyés par les miroirs coïncident avec les zones séparant les sous-modules du module à tester, qui ne sont pas fonctionnelles en termes de conversion photovoltaïque.

Pour des raisons d'assemblage des modules, il existe en effet, comme on peut le voir sur la figure 1A, un espace entre deux sous-modules 10 adjacents, au niveau duquel il ne se produit aucune conversion photovoltaïque.

Ainsi, si d'éventuels défauts d'uniformité se produisent dans ces zones, ces défauts n'ont pas d'effet négatif sur la qualité du test.

Pour permettre ce réglage, le dispositif de test est conçu de telle sorte qu'un ajustement de la position et de l'orientation de chaque miroir soit possible.

Un jeu est avantageusement prévu entre les miroirs pour permettre de tels ajustements.

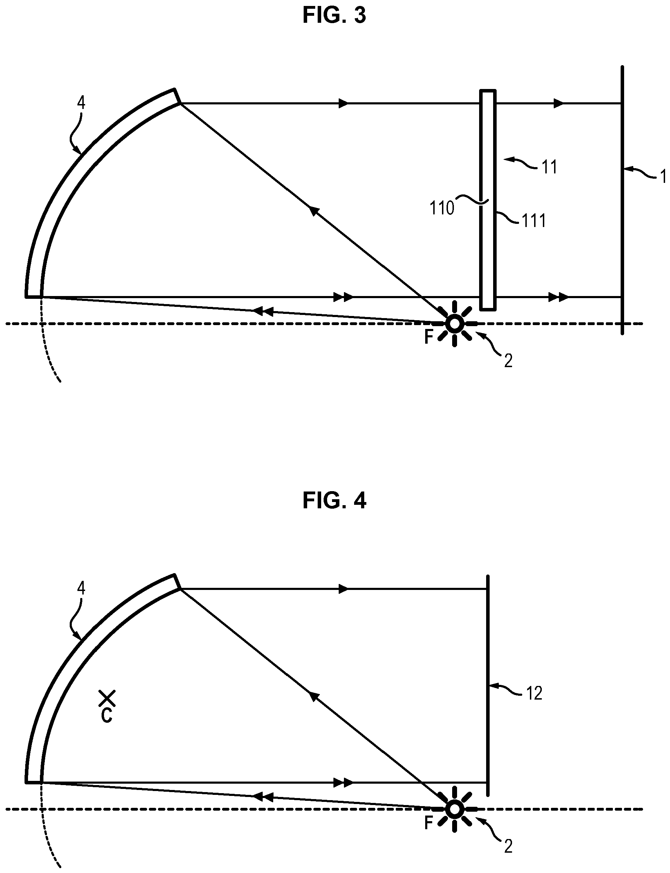

Comme illustré sur la figure 3, pour compenser les imperfections de forme d'un miroir parabolique 4 qui affectent l'uniformité de l'intensité du faisceau lumineux quasi collimaté, un filtre d'intensité 11 est interposé sur le trajet du faisceau, en amont du module 1.

Le filtre d'intensité 11 comprend des régions au moins partiellement absorbantes à densité spectrale neutre vis-à-vis du faisceau lumineux.

Par « absorbant à densité spectrale neutre » on entend que la région considérée du filtre bloque en intensité de manière équivalente toutes les longueurs d'onde du faisceau lumineux. Il ne s'agit pas dans ce cas d'une absorption sélective d'une gamme de longueurs d'onde déterminée.

Le filtre 11 est spécifiquement adapté au miroir 4, c'est-à-dire que les régions au moins partiellement absorbantes du filtre sont agencées en vis-à-vis des zones de plus forte intensité du faisceau.

Eventuellement, le filtre 11 peut être spécifiquement adapté à un couple miroir - source lumineuse, ce qui permet de compenser d'éventuels défauts d'homogénéité de la source en plus de ceux du miroir.

Ainsi, les régions au moins partiellement absorbantes permettent de diminuer l'intensité du faisceau qui les traverse.

D'autres régions du filtre sont transparentes ou moins absorbantes, de sorte à transmettre la totalité du faisceau lumineux ou une grande partie de l'intensité de celui-ci, dans les zones du faisceau qui présentent une intensité plus faible.

En pratique, la répartition des régions au moins partiellement absorbantes sur le filtre, et le degré d'absorption desdites régions, correspondent sensiblement au négatif de la répartition de l'intensité du faisceau lumineux.

Ainsi, le filtre permet d'atténuer les différences d'intensité du faisceau et de procurer une uniformité améliorée de l'intensité qui parvient au module.

La mise en oeuvre d'un tel filtre permet d'utiliser des miroirs paraboliques présentant une qualité inférieure à celle des miroirs utilisés dans les flashers connus, ce qui diminue sensiblement le coût des miroirs.

En particulier, on peut ainsi utiliser des miroirs paraboliques qui sont réalisés par des procédés peu onéreux, par exemple par thermoformage d'une plaque de verre ou d'un matériau plastique suivi du revêtement d'un film réfléchissant ou d'un empilement de couches minces réfléchissantes.

Selon un mode de réalisation, illustré sur la figure 3, le filtre 11 comprend un support 110 transparent audit faisceau quasi collimaté et un film 111 collé sur ledit support 110, ledit film 111 comprenant les régions absorbantes mentionnées plus haut.

Selon un autre mode de réalisation, non illustré ici, le filtre d'intensité comprend un support transparent au faisceau quasi collimaté et une couche d'impression appliquée sur ledit support pour former lesdites régions absorbantes.

Le support est plan pour ne pas déformer le faisceau quasi collimaté et est positionné perpendiculairement audit faisceau.

De manière particulièrement avantageuse, le support est une plaque de verre.

La figure 4 illustre l'agencement d'un dispositif permettant de définir un filtre d'intensité adapté à un miroir déterminé.

La source lumineuse 2 est agencée au foyer F du miroir 4, de sorte que le miroir 4 renvoie la lumière émise par la source en un faisceau quasi collimaté.

On place un écran 12 de teinte uniforme sur le trajet dudit faisceau, perpendiculairement à celui-ci.

On place un capteur d'image à un emplacement C faisant face à l'écran 12, et l'on enregistre une image du faisceau projeté sur l'écran 12.

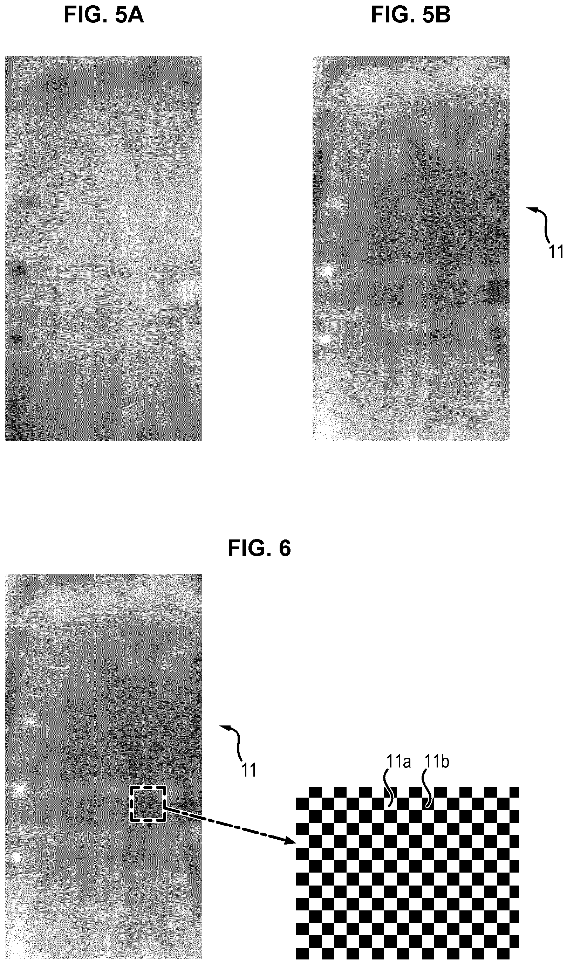

On obtient ainsi une cartographie de l'intensité du faisceau, telle qu'illustrée sur la figure 5A.

Comme on peut le voir, l'intensité du faisceau est représentée par des niveaux de gris (les zones les plus claires présentant l'intensité la plus forte) et n'est pas uniforme.

On crée alors un négatif de cette image, illustré sur la figure 5B, présentant des régions foncées plus absorbantes en vis-à-vis des zones claires de l'image du faisceau lumineux, et des régions claires transparentes ou moins absorbantes en vis-à-vis des zones foncées de l'image du faisceau lumineux.

C'est cette image négative qui est utilisée pour former le filtre d'intensité 11.

Selon un mode de réalisation, cette image négative est imprimée sur un film qui est lui-même appliqué sur un support transparent au faisceau lumineux.

De manière particulièrement avantageuse, le film est un film autoadhésif transparent destiné à être collé sur le support après impression.

De manière alternative, l'image négative est directement formée sur un support transparent par un procédé d'impression.

De manière particulièrement avantageuse, avant la réalisation du filtre, l'image négative est transformée en un ensemble binaire de motifs élémentaires comprenant des motifs 11a transparents et des motifs 11b opaques au faisceau lumineux.

Sur l'exemple de la figure 6, on a représenté de manière grossie une région du filtre sous la forme d'un damier constitué de carrés transparents 11a et de carrés noirs absorbants 11b.

Naturellement, on pourra choisir toute autre forme de motifs élémentaires sans pour autant sortir du cadre de l'invention, la forme et la dimension des motifs pouvant en outre varier d'une région à l'autre du filtre..

Le degré d'absorption du filtre vis-à-vis du faisceau lumineux peut en effet être modulé par la forme et la dimension des différents motifs.

Selon la région du filtre, on pourra donc trouver des motifs de différentes formes et/ou dimensions pour procurer l'absorption souhaitée.

A titre purement indicatif, pour des motifs de forme carrée, la longueur du côté est comprise entre 0,5 et 10 mm.

Cette binarisation de l'image négative permet de fabriquer le filtre en utilisant simplement une impression d'encre noire pour former les motifs élémentaires absorbants.

Dans le cas du test d'un module de grandes dimensions, on fabrique pour chaque miroir parabolique du dispositif de test un filtre d'intensité correspondant, et l'on installe chaque filtre sur le trajet du faisceau lumineux renvoyé par le miroir correspondant.

## Revendications

1. Dispositif de test d'un module photovoltaïque à concentration (1) comprenant au moins un ensemble d'une cellule photovoltaïque et d'un concentrateur agencé par rapport à la cellule pour concentrer vers ladite cellule un rayonnement arrivant en incidence normale, ledit dispositif comprenant :
- au moins une source lumineuse (2),
- au moins un miroir parabolique (4) couplé à ladite source (2) de manière à renvoyer la lumière issue de ladite source dans un faisceau lumineux quasi collimaté vers le module (1) à tester, dans une direction perpendiculaire à la surface dudit module, et
- un filtre d'intensité (11) interposé sur le trajet du faisceau quasi collimaté en amont du module (1) à tester, ledit filtre (11) comprenant des régions au moins partiellement absorbantes à densité spectrale neutre vis-à-vis du faisceau lumineux, lesdites régions au moins partiellement absorbantes étant agencées en vis-à-vis des zones de plus forte intensité du faisceau, de sorte à atténuer les différences d'intensité du faisceau.

2. Dispositif selon la revendication 1, le filtre d'intensité (11) comprenant un support (110) transparent audit faisceau quasi collimaté et un film (111) collé sur ledit support (110), ledit film (111) comprenant des régions au moins partiellement absorbantes à densité spectrale neutre vis-à-vis du faisceau quasi collimaté, lesdites régions au moins partiellement absorbantes correspondant aux zones de plus forte intensité du faisceau.

3. Dispositif selon la revendication 1, le filtre d'intensité (11) comprenant un support (110) transparent audit faisceau quasi collimaté, ledit support (110) comprenant une couche d'impression comportant des régions au moins partiellement absorbantes à densité spectrale neutre vis-à-vis du faisceau quasi collimaté, lesdites régions au moins partiellement absorbantes correspondant aux zones de plus forte intensité du faisceau.

4. Dispositif selon l'une des revendications 2 ou 3, lesdites régions au moins partiellement absorbantes du filtre (11) étant constituées de motifs élémentaires (11a, 11b), lesdits motifs comprenant des motifs (11a) transparents et des motifs (11b) opaques au faisceau lumineux.

5. Dispositif selon la revendication 4, lesdits motifs élémentaires (11a, 11b) présentant une forme carrée ou rectangulaire.

6. Dispositif selon l'une des revendications 1 à 5, le miroir parabolique (4) comprenant une plaque de verre ou de plastique recouverte d'un film réfléchissant ou d'un empilement de couches minces réfléchissantes.

7. Dispositif selon l'une des revendications 1 à 6, adapté pour tester un module photovoltaïque à concentration (1) comprenant une pluralité de sous-modules photovoltaïques (10) comprenant chacun au moins un ensemble d'une cellule photovoltaïque et d'un concentrateur, ledit dispositif comprenant une pluralité de sources lumineuses (2) et une pluralité de miroirs paraboliques (4) couplés auxdites sources (2) de manière à envoyer des faisceaux quasi collimatés vers le module à tester et en ce qu'un filtre d'intensité (11) est interposé sur le trajet de chaque faisceau quasi collimaté en amont du module à tester, chaque filtre d'intensité comprenant des régions au moins partiellement absorbantes à densité spectrale neutre vis-à-vis du faisceau lumineux, lesdites régions au moins partiellement absorbantes étant agencées en vis-à-vis des zones de plus forte intensité du faisceau, de sorte à atténuer les différences d'intensité de chaque faisceau.

8. Dispositif selon la revendication 7, comprenant un support (3) pour le module à tester et en ce que les sources lumineuses (2) sont agencées selon deux rangées s'étendant de part et d'autre de l'emplacement du module (1) sur ledit support (3).

9. Dispositif selon la revendication 8, les miroirs paraboliques (4) étant agencés de sorte à former deux rangées horizontales en vis-à-vis du support (3) du module à tester.

10. Procédé de test d'un module photovoltaïque à concentration (1), ledit module comprenant au moins un ensemble d'une cellule photovoltaïque et d'un concentrateur agencé par rapport à la cellule pour concentrer vers ladite cellule un rayonnement arrivant en incidence normale, ledit procédé comprenant l'étape d'envoyer vers ledit module (1) au moins un faisceau lumineux quasi collimaté au moyen d'au moins une source lumineuse (2) couplée à un miroir parabolique (4), et en ce que l'on interpose sur le trajet dudit faisceau lumineux quasi collimaté en amont du module à tester, un filtre d'intensité (11) comprenant des régions au moins partiellement absorbantes à densité spectrale neutre vis-à-vis du faisceau lumineux, lesdites régions au moins partiellement absorbantes étant agencées en vis-à-vis des zones de plus forte intensité du faisceau, de sorte à atténuer les différences d'intensité du faisceau.

11. Procédé selon la revendication 10, comprenant l'étape de former ledit filtre d'intensité (11) en collant, sur un support (110) transparent audit faisceau quasi collimaté, un film (111) comprenant des régions au moins partiellement absorbantes vis-à-vis du faisceau quasi collimaté, lesdites régions au moins partiellement absorbantes correspondant aux zones de plus forte intensité du faisceau.

12. Procédé selon la revendication 10, comprenant l'étape de former ledit filtre d'intensité (11) en imprimant, sur un support (110) transparent audit faisceau quasi collimaté, des régions au moins partiellement absorbantes à densité spectrale neutre vis-à-vis du faisceau quasi collimaté, lesdites régions au moins partiellement absorbantes correspondant aux zones de plus forte intensité du faisceau.

13. Procédé selon l'une des revendications 10 à 12, comprenant l'étape de former le miroir parabolique en thermoformant une plaque de verre puis en la recouvrant d'un film réfléchissant ou d'un empilement de couches minces réfléchissantes.

14. Procédé selon l'une des revendications 10 à 13, le module photovoltaïque (1) à tester comprenant une pluralité de sous-modules photovoltaïques (10) et en ce que l'on envoie vers ledit module (1) une pluralité de faisceaux lumineux quasi collimatés au moyen d'une pluralité de sources lumineuses (2) couplées à une pluralité de miroirs paraboliques (4), et en ce que l'on interpose sur le trajet de chaque faisceau lumineux quasi collimaté en amont du module à tester, un filtre d'intensité (11) comprenant des régions au moins partiellement absorbantes à densité spectrale nulle vis-à-vis du faisceau lumineux, lesdites régions au moins partiellement absorbantes étant agencées en vis-à-vis des zones de plus forte intensité du faisceau, de sorte à atténuer les différences d'intensité de chaque faisceau.

15. Procédé selon la revendication utilisant autant de sources lumineuses (2), de miroirs paraboliques (4) et de filtres d'intensité (11) que de sous-modules (10) du module photovoltaïque à tester, chaque source lumineuse (2) et chaque miroir parabolique (4) étant couplés de sorte à envoyer un faisceau lumineux quasi collimaté vers un sous-module (10) correspondant.

16. Procédé selon l'une des revendications 14 ou 15, la surface du module (1) à tester étant supérieure ou égale à 8 m².

17. Procédé selon l'une des revendications 10 à 16, comprenant l'étape de définir les régions au moins partiellement absorbantes du filtre d'intensité (11) en mettant en oeuvre les étapes suivantes :
- acquisition d'une image du faisceau quasi collimaté provenant du miroir parabolique (4),
- détermination, sur ladite image, des zones du faisceau de plus forte intensité,
- décomposition desdites zones de l'image en motifs élémentaires,
- attribution à chaque motif élémentaire d'un caractère transparent ou opaque vis-à-vis du flux lumineux, de sorte à former, en vis-à-vis desdites zones de plus forte intensité du faisceau lumineux, des régions au moins partiellement absorbantes constituées desdits motifs.

## Patentansprüche

1. Vorrichtung zum Testen eines konzentrierenden Photovoltaikmoduls (1) umfassend mindestens eine Anordnung aus einer photovoltaischen Zelle und einem relativ zur Zelle angeordneten Konzentrator zur Konzentrierung einer normal einfallenden Strahlung in Richtung der Zelle, wobei die Vorrichtung Folgendes umfasst:
- mindestens eine Lichtquelle (2),
- mindestens einen Parabolspiegel (4), der derart mit der Quelle (2) gekoppelt ist, dass das von der Quelle kommende Licht in einem quasi kollimierten Lichtstrahl zum zu testenden Moduls (1) in einer zur Fläche des Moduls senkrechten Richtung zurückgestrahlt wird, und
- einen Intensitätsfilter (11), der auf dem Weg des quasi kollimierten Strahls, dem zu testenden Modul (1) vorgelagert angeordnet ist, wobei der Filter (11) zumindest teilweise absorbierende Bereiche mit in Bezug auf den Lichtstrahl neutraler Spektraldichte aufweist, wobei die zumindest teilweise absorbierenden Bereiche gegenüber den Gebieten mit höherer Intensität des Lichtstrahls angeordnet sind, um die Intensitätsunterschiede des Strahls zu mildern.

2. Vorrichtung nach Anspruch 1, wobei der Intensitätsfilter (11) einen den quasi kollimierten Strahl durchlässigen Träger (110) und einen auf den Träger (110) aufgeklebten Film (111) umfasst, wobei der Film (111) zumindest teilweise absorbierende Bereiche mit in Bezug auf den quasi kollimierten Strahl neutraler Spektraldichte aufweist, wobei die zumindest teilweise absorbierenden Bereiche den Gebieten mit höherer Intensität des Strahls entsprechen.

3. Vorrichtung nach Anspruch 1, wobei der Intensitätsfilter (11) einen den quasi kollimierten Strahl durchlässigen Träger (110) umfasst, wobei der Träger (110) eine gedruckte Schicht umfasst, die zumindest teilweise absorbierende Bereiche mit in Bezug auf den quasi kollimierten Strahl neutraler Spektraldichte aufweist, wobei die zumindest teilweise absorbierenden Bereiche den Gebieten mit höherer Intensität des Strahls entsprechen.

4. Vorrichtung nach einem der Ansprüche 2 bis 3, wobei die zumindest teilweise absorbierenden Bereiche des Filters (11) aus elementaren Mustern (11a, 11b) bestehen, wobei die Muster transparente Muster (11a) und für den Lichtstrahl undurchlässige Muster (11b) umfassen.

5. Vorrichtung nach Anspruch 4, wobei die elementaren Muster (11a, 11b) eine quadratische oder rechteckige Form aufweisen.

6. Vorrichtung nach einem der Ansprüche 1 bis 5, wobei der Parabolspiegel (4) eine Glas- oder Kunststoffplatte umfasst, die mit einem reflektierenden Film oder einem Stapel von dünnen reflektierenden Schichten bedeckt ist.

7. Vorrichtung nach einem der Ansprüche 1 bis 6, die dazu geeignet ist, ein konzentrierendes Photovoltaikmodul (1) zu testen, das eine Vielzahl von photovoltaischen Submodulen (10) umfasst, die jeweils mindestens eine Anordnung aus einer photovoltaischen Zelle und einem Konzentrator umfassen, wobei die Vorrichtung eine Vielzahl von Lichtquellen (2) und eine Vielzahl von Parabolspiegeln (4) umfasst, die derart mit den Quellen (2) gekoppelt sind, dass sie quasi kollimierte Strahlen an das zu testende Modul senden, und wobei ein Intensitätsfilter (11) auf dem Weg des quasi kollimierten Strahls, dem zu testenden Modul (1) vorgelagert angeordnet ist, wobei jeder Intensitätsfilter zumindest teilweise absorbierende Bereiche mit in Bezug auf den Lichtstrahl neutraler Spektraldichte aufweist, wobei die zumindest teilweise absorbierenden Bereiche gegenüber den Gebieten mit höherer Intensität des Strahls angeordnet sind, um die Intensitätsunterschiede jedes Strahls zu mildern.

8. Vorrichtung nach Anspruch 7, umfassend einen Träger (3) für das zu testende Modul und bei der die Lichtquellen (2) in zwei Reihen angeordnet sind, die sich beidseitig der Stelle erstrecken, an der das Modul (1) auf dem Träger (3) angeordnet ist.

9. Vorrichtung nach Anspruch 8, bei der die Parabolspiegel (4) derart angeordnet sind, dass sie zwei dem Träger (3) des zu testenden Moduls gegenüberliegende horizontale Reihen bilden.

10. Verfahren zum Testen eines konzentrierenden Photovoltaikmoduls (1), wobei das Modul mindestens eine Anordnung aus einer photovoltaischen Zelle und einem relativ zur Zelle angeordneten Konzentrator zur Konzentrierung einer normal einfallenden Strahlung in Richtung der Zelle umfasst, wobei das Verfahren einen Schritt des Sendens umfasst, bei dem mittels mindestens einer mit einem Parabolspiegel (4) gekoppelten Lichtquelle (3), mindestens ein quasi kollimierter Lichtstrahl an das zu testende Modul (1) gesendet wird, und wobei ein Intensitätsfilter (11) auf dem Weg des quasi kollimierten Lichtstrahls, dem zu testenden Moduls vorgelagert angeordnet ist, wobei ein Intensitätsfilter (11) zumindest teilweise absorbierende Bereiche mit in Bezug auf den Lichtstrahl neutraler Spektraldichte aufweist, wobei die zumindest teilweise absorbierenden Bereiche gegenüber den Gebieten mit höherer Intensität des Strahls angeordnet sind, um die Intensitätsunterschiede des Strahls zu mildern.

11. Vorrichtung nach Anspruch 10, umfassend einen Schritt, bei dem der Intensitätsfilter (11) dadurch gebildet wird, dass auf einen den quasi kollimierten Strahl durchlässigen Träger (110) ein Film (111) aufgeklebt wird, der zumindest teilweise absorbierende Bereiche mit in Bezug auf den quasi kollimierten Strahl neutraler Spektraldichte aufweist, wobei die zumindest teilweise absorbierenden Bereiche den Gebieten mit höherer Intensität des Strahls entsprechen.

12. Vorrichtung nach Anspruch 10, umfassend einen Schritt, bei dem der Intensitätsfilter (11) dadurch gebildet wird, dass auf einen den quasi kollimierten Strahl durchlässigen Träger (110) Bereiche mit in Bezug auf den quasi kollimierten Strahl neutraler Spektraldichte gedruckt werden, wobei die zumindest teilweise absorbierenden Bereiche den Gebieten mit höherer Intensität des Strahls entsprechen.

13. Vorrichtung nach einem der Ansprüche 10 bis 12, umfassend einen Schritt, bei dem der Parabolspiegel dadurch gebildet wird, dass eine Glasplatte thermogeformt wird und anschließend mit einem reflektierenden Film oder einem Stapel von dünnen reflektierenden Schichten bedeckt wird.

14. Vorrichtung nach einem der Ansprüche 10 bis 13, wobei das zu testende Photovoltaikmodul (1) eine Vielzahl von photovoltaischen Submodulen (10) umfasst und wobei mittels einer Vielzahl von mit einer Vielzahl von Parabolspiegeln (4) gekoppelten Lichtquellen (3), eine Vielzahl von quasi kollimierten Lichtstrahlen an das Modul (1) gesendet werden, und wobei auf dem Weg jedes quasi kollimierten Lichtstrahls, dem zu testenden Moduls vorgelagert, ein Intensitätsfilter (11) angeordnet ist, der zumindest teilweise absorbierende Bereiche mit in Bezug auf den Lichtstrahl neutraler Spektraldichte aufweist, wobei die zumindest teilweise absorbierenden Bereiche gegenüber den Gebieten mit höherer Intensität des Strahls angeordnet sind, um die Intensitätsunterschiede jedes Strahls zu mildern.

15. Vorrichtung nach Anspruch 11, bei der genauso viele Lichtquellen (2), Parabolspiegel (4) und Intensitätsfilter (11) wie Submodule (10) des zu testenden Photovoltaikmoduls verwendet werden, wobei jede Lichtquelle (2) und jeder Parabolspiegel (4) derart miteinander gekoppelt sind, dass ein quasi kollimierter Lichtstrahl zu einem entsprechenden Submodul (10) gesendet wird.

16. Vorrichtung nach einem der Ansprüche 14 oder 15, bei der die Fläche des zu testenden Moduls (11) grösser oder gleich 8 m² ist.

17. Vorrichtung nach einem der Ansprüche 10 bis 16, umfassend einen Schritt, bei dem die zumindest teilweise absorbierenden Bereiche des Intensitätsfilters (11) durch Umsetzung folgender Schritte bestimmt werden:
- Erfassung eines Bildes des vom Parabolspiegel (4) kommenden quasi kollimierten Strahls,
- Bestimmung der Gebiete mit höherer Intensität des Strahls auf dem Bild,
- Zerlegung der Gebiete des Bilds in elementare Muster,
- Zuweisung an jedes elementare Muster einer Transparenz oder Undurchlässigkeit gegenüber dem Lichtstrom, um gegenüber den Gebieten mit höherer Intensität des Lichtstrahls zumindest teilweise absorbierende Bereiche zu bilden, die aus den Mustern bestehen.

## Claims

1. A device for testing a concentrating photovoltaic module (1) comprising at least one assembly of a photovoltaic cell and a concentrator arranged relative to the cell in such a manner as to concentrate a radiation arriving at normal incidence toward the cell, said device comprising:
- at least one light source (2),
- at least one parabolic mirror (4) coupled to said source (2) so as to reflect the light emitted by said source in an almost collimated light beam toward the module (1) to be tested, in a direction perpendicular to the surface of said module, and
- an intensity filter (11) interposed on the path of the almost collimated beam upstream of the module (1) to be tested, said filter (11) comprising at least partially absorbent regions that have a neutral spectral density with respect to the light beam, said at least partially absorbent regions being arranged facing higher intensity zones of the beam, so as to attenuate differences in the intensity of the beam.

2. The device according to claim 1, the intensity filter (11) comprising a support (110) that is transparent to said almost collimated beam and a film (111) glued to said support (110), said film (111) comprising at least partially absorbent regions that have a neutral spectral density with respect to the almost collimated beam, said at least partially absorbent regions corresponding to the higher intensity zones of the beam.

3. The device according to claim 1, the intensity filter (11) comprising a support (110) that is transparent to said almost collimated beam, said support (110) comprising a printed layer comprising at least partially absorbent regions that have a neutral spectral density with respect to the almost collimated beam, said at least partially absorbent regions corresponding to the higher intensity zones of the beam.

4. The device according to one of the claims 2 or 3, said at least partially absorbent regions of the filter (11) consisting of elementary patterns (11a, 11b), said patterns comprising transparent patterns (11a) and patterns (11b) that are opaque to the light beam.

5. The device according to claim 4, said elementary patterns (11a, 11b) having a square or rectangular shape.

6. The device according to one of the claims 1 to 5, the parabolic mirror (4) comprising a glass or plastic panel covered with a reflective film or a stack of thin reflective layers.

7. The device according one of the claims 1 to 6, adapted for testing a concentrating photovoltaic module (1) comprising a plurality of photovoltaic sub-modules (10) each comprising at least one assembly of a photovoltaic cell and a concentrator, said device comprising a plurality of light sources (2) and a plurality of parabolic mirrors (4) coupled with said sources, so as to send almost collimated beams toward the module (1) to be tested, and an intensity filter (11) being interposed on the path of each almost collimated beam upstream of the module to be tested, each intensity filter comprising at least partially absorbent regions that have a neutral spectral density with respect to the light beam, said at least partially absorbent regions being arranged facing higher intensity zones of the beam, so as to attenuate differences in the intensity of the beam.

8. The device according to claim 7, comprising a support (3) for the module to be tested and the light sources (2) being arranged in two rows extending on both sides of the location of the module (1) on said support (3).

9. The device according to claim 8, the parabolic mirrors (4) being arranged so as to form two horizontal rows facing the support (3) of the module to be tested.

10. A method for testing a concentrating photovoltaic module (1), said module comprising at least one assembly of a photovoltaic cell and a concentrator arranged relative to the cell in such a manner as to concentrate a radiation arriving at normal incidence toward the cell, said method comprising the steps of sending toward said module (1) at least one almost collimated light beam of at least one light source (2) coupled to a parabolic mirror (4), and of interposing on the path of the almost collimated light beam upstream of the module (1) to be tested an intensity filter (11) comprising at least partially absorbent regions that have a neutral spectral density with respect to the light beam, said at least partially absorbent regions being arranged facing higher intensity zones of the beam, so as to attenuate differences in the intensity of the beam.

11. The method according to claim 10, comprising the step of forming said intensity filter (11) by gluing onto a support (110) that is transparent to said almost collimated beam a film (111) comprising at least partially absorbent regions with respect to the almost collimated beam, said at least partially absorbent regions corresponding to the higher intensity zones of the beam.

12. The method according to claim 10, comprising the step of forming said intensity filter (11) by printing, onto a support (110) that is transparent to said almost collimated beam, at least partially absorbent regions that have a neutral spectral density with respect to the almost collimated beam, said at least partially absorbent regions corresponding to the higher intensity zones of the beam.

13. The method according to one of the claims 10 to 12, comprising the step of forming the parabolic mirror by thermoforming a glass panel and covering it with a reflective film or a stack of thin reflective layers.

14. The method according to one of the claims 10 to 13, the photovoltaic module (1) to be tested comprising a plurality of photovoltaic sub-modules (10), and a plurality of almost collimated light beams being sent toward the module (1) by a plurality of light sources (2) coupled to a plurality of parabolic mirrors (4), and an intensity filter (11) being interposed on the path of each almost collimated light beam upstream of the module to be tested, said filter comprising at least partially absorbent regions that have a neutral spectral density with respect to the light beam, said at least partially absorbent regions being arranged facing higher intensity zones of the beam, so as to attenuate differences in the intensity of each beam.

15. The method according to claim 11, using as many light sources (2), parabolic mirrors (4) and intensity filters (11) as sub-modules (10) of the photovoltaic module to be tested, each light source (2) et each parabolic mirror (4) being coupled so as to send an almost collimated light beam toward a corresponding sub-module (10).

16. The method according to one of the claims 14 or 15, the surface area of the module (1) to be tested being greater or equal to 8 m².

17. The method according to one of the claims 10 to 16, comprising the step of defining the at least partially absorbent regions of the intensity filter (11) by carrying out the following steps:
- acquiring an image of the almost collimated beam coming from the parabolic mirror (4),
- determining, on said image, higher intensity zones of the beam,
- decomposing said zones of the image into elementary patterns,
- attributing to each elementary pattern a transparency or opacity to the luminous flux, so as to form at least partially absorbent regions comprised of the patterns, facing higher intensity zones of the light beam.
